# EUROPEAN PATENT SPECIFICATION

(11) **EP 0 746 638 B1**
(45) Date of publication and mention of the grant of the patent: **29.12.1999**
(21) Application number: 95909055.6
(22) Date of filing: 24.02.1995
(51) Int. Cl.: C23F 1/02, C23F 1/08

(54) **SURFACE TREATMENT OF AN OBJECT**
OBERFLÄCHENBEHANDLUNG EINES GEGENSTANDES
TRAITEMENT DE LA SURFACE D'UN OBJET

(30) Priority: 25.02.1994 GB 9403682
(43) Date of publication of application: 11.12.1996
(73) Proprietor: THE UNIVERSITY OF EDINBURGH, South Bridge, Edinburgh EH8 9YL (GB)
(72) Inventor: MUHL, Jonathan, Peebles EH45 8HQ (GB)
(74) Representative: Newby, Martin John
(86) International application number: GB9500396
(87) International publication number: WO9523244

(56) References cited:
- EP-A- 0 338 816
- EP-A- 0 559 900
- US-A- 4 588 486
- US-A- 4 767 489
- PATENT ABSTRACTS OF JAPAN vol. 010 no. 022 (P-424) ,28 January 1986 & JP,A,60 175050 (NIPPON DENKI KK) 9 September 1985,
- IBM TECHNICAL DISCLOSURE BULLETIN, vol. 15,no. 9, February 1973 NEW YORK, US, pages 2841-2842, ANONYMOUS 'Forming Metallized Patterns on Ceramic Substrates February 1973.'

## Description

### Technical field

This invention relates to a method of treating an object according to the preamble of claim 1 and to a method of applying a permanent pattern according to the preamble of claim 2. In particular, but not exclusively, the invention relates to a method of etching a desired surface pattern onto an object which may not be of even geometry in all axes. Typically, for example, the invention finds application in applying a desired surface finish to a steel roller of a rolling mill, in applying wording, logos, bar codes or the like to flat, curved or other non-linear metallic surfaces or in the manufacture of printed circuit boards. The invention also relates to an apparatus for treating an object and to a method of providing a product on a production line.

### Background Art

In order to impart a desired surface finish or texture to steel sheets, e.g. for use in vehicle panels, it is known to provide rollers in the final temper rolling stage of a cold strip mill with a surface texture. The finish imparted by such surface textured rollers to the sheet steel may influence the painted appearance, coating adhesion and formability of the sheet steel.

At present there are four known techniques for surface texturing a roller. The traditional process is shot blast texturing (SBT). This involves firing particles of aluminium oxide or other hard material at the surface of the roller. However, this leads to limitations in the hardness of the roller as it must be softer than the shot being used to texture it. It also suffers by being difficult to accurately control, resulting in wide variations of peak height and a poor bearing ratio. This combined with the hardness limitation also reduces the wearability and thus the service life of the roller.

The SBT technique for surface texturing a roller has been widely replaced by the more recent processes of electrical discharge texturing (EDT), laser texturing (LT) and electron beam texturing (EBT). All these processes offer greater control than SBT and are effectively independent of roller hardness. The EDT approach is based on the well established process of electro-discharge machining. The roller is mounted on a lathe, grinding machine or the like, and is rotated at a constant velocity while the tool electrode is traversed along its length at constant rate on a zero backlash servo system. A dielectric fluid such as paraffin flows between the tool and the roller. This breaks down when a suitable voltage is applied across the electrodes, the resulting spark melting a small crater in the surface of the roll. By controlling the frequency, duration and current of the spark different surface roughnesses can be created.

The LT process uses a laser beam to remove material from the surface of the roller. The unfocussed beam is chopped by a rotating disk then focused into a spot, typically 0.1 mm diameter, on the roller surface. This causes the metal to first melt and then vaporise. When the beam is removed the surface cools leaving a pit. The rotation of the roller and the pulsing frequency of the beam set the spacing of the craters, and thus the peak count on the textured sheet. This produces a surface which has reportedly good pressing and painting performance, although there have been reports of the regular pattern of the texture causing diffraction patterns on the surface of the painted sheet.

EBT is similar to the LT process but uses an electron beam to provide a highly controllable energy source for material removal. Equipment costs appear to be high and the machining must take place in a vaccum.

The random processes, SBT and EDT, have a large waviness (λ > 0.8mm) component in their texture (particularly SBT) which has been linked to a reduction in image clarity of the painted sheet.

A known technique for treating generally flat metallic surfaces is the conventional etching process known as photochemical machining. This process involves coating the metallic surface of a workpiece with a light-sensitive chemical or photo-resist. A desired image is projected onto the surface to selectively expose the photo-resist coating. A developing solution is then used to strip or remove all areas to be exposed to a chemical etchant. However a disadvantage of this known process is that it is difficult to expose the required images onto a curved or non-flat surface. Also there are a number of process stages involved.

Other known processes for masking and etching surfaces, e.g. non-flat surfaces, are described in JP-A-60 175 050 and US-A-4 767 489.

The present invention seeks to provide a novel and relatively simple method of treating an object by selectively removing material from the surface of the object. The invention involves a novel method of masking surfaces, e.g. metallic surfaces, which may be flat, cylindrical or of other non-planar form, in a surface treating process.

### Disclosure of Invention

According to one aspect of the present invention there is provided a method of treating an object as claimed in the ensuing claim 1.

Rollers treated by the method of the present invention are typically intended to contact and surface treat or texture other articles. Such surface treated rollers may be used, for example, to coat, roll or press the other articles which may be metallic or non-metallic. Examples of articles which can be so treated are rolled steel, paper or plastic sheet, plated or painted components, overlaid plain bearings and the like. A metallic roller may have its treated, e.g. textured, surface subsequently coated with ceramic or polymer material to give the roller hard wearing or low friction surface properties beneficial when treating other articles.

According to another aspect of the present invention there is provided a method of applying a pattern to an object, which may be flat or non-flat, e.g. curved, by the method claimed in the ensuing claim 2.

Preferably the masking material is printed onto the object surface under computer control to provide the said desired pattern of masked and unmasked surface areas. Different patterns of masked and unmasked surface areas can thus be produced under software control. A wide range of computer-controlled printing techniques can also be used to provide the desired pattern.

Preferably the masking material is applied to the object surface by a printing head of an ink jet printing device. By the use of computer control, the position of the printing head relative to the object surface can be accurately controlled. Conveniently the printing head has a nozzle diameter of less than 50 microns, e.g. 36 microns, and provides a dot frequency of typically up to 80 KHz. Typically the ink jet printing device has a resolution of at least 170 dots per inch. The masking material suitably comprises, for example, a solvent based ink or a hot melt type of ink.

Preferably the object to be treated has a metallic, e.g. a steel, surface. In this case the masking material may comprise a solvent based ink. The surface treating may comprise chemical etching using a suitable chemical etchant, e.g. ferric chloride solution, electro-chemical or pulsed electro-chemical etching. If pulsed electro-chemical etching is employed, both the crater depth and profile can be controlled by varying the pulse duration and current.

The treating of the partially masked surface may comprise photo-, electro-, chemical or laser machining or etching.

The method may be incorporated into a combined printing/treating (etching) system under computer control or otherwise although, alternatively, these process steps may be performed independently.

### Brief Description of Drawings

Embodiments of the invention will now be described, by way of example only, with particular reference to the accompanying drawings, in which:
Figure 1 is a schematic view of apparatus for directly applying masking material onto a surface of a steel roller under computer control;
Figure 2 shows a plot depicting the surface profile of a section of a steel roller;
Figures 3 and 4 show plots depicting the surface profiles of a section of steel strip after and before, respectively, being rolled in a roll mill by a steel roller with a surface finish of the type depicted in Figure 2; and
Figures 4 and 5 show plots depicting fine and coarse surface textures of sections of conventionally textured steel sheet.

### Best Modes of Carrying Out the Invention

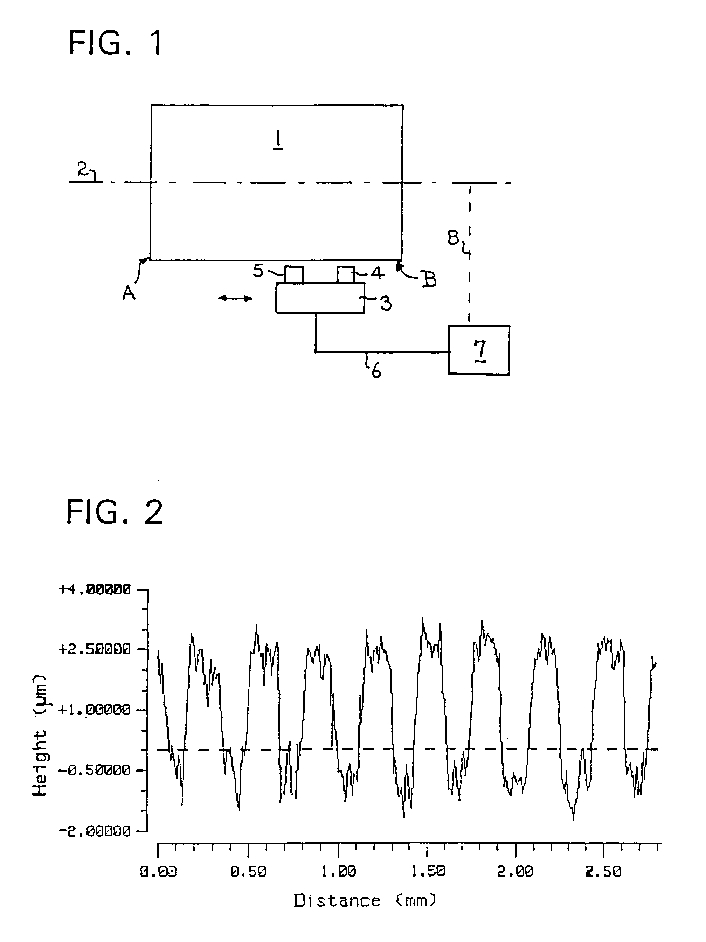

Figure 1 shows apparatus for carrying out a method of treating the surface of a steel roller 1. The roller 1 after treatment is intended to roll steel sheet in the final temper rolling stage of a cold strip mill (not shown) and typically may have a diameter of 300 mm and a length of 2 m. The surface treatment of the steel roller 1 is intended to provide a desired surface texture to the roller 1 so that a desired surface finish is imparted to steel sheet rolled by the roller 1 in a rolling mill. Such a surface finish may influence the painted appearance, coating adhesion and formability of the sheet steel.

The roller 1 is mounted for rotation about its longitudinal axis 2 in mounting means (not shown). The mounting means should be capable of rotating the roller 1 at a controllable set speed of rotation. A carrier 3 is mounted for traversing movement parallel to the axis 2 and carries an ink-jet print head 4 and a pulsed electro-chemical etching head 5. A control cable 6 is connected between the carrier 3 and a computer 7 for enabling the computer to control the operation of the print head 4, the operation of the etching head 5 and the traverse speed of the carrier 3. A further control cable 8 is schematically shown connected to the computer 7 for enabling the computer 7 to receive signals from means (not shown) sensing the speed of rotation of the roller 1 and for sending signals to control the speed of rotation of the roller 1 and/or the speed of printing of the print head 4.

In use, the carrier 3 traverses from one end A to the other end B of the roller 1 at a constant speed, typically of about 2 mm/s, as the roller 1 is rotated at a constant surface speed, typically of about 750 mm/s. The print head 4 directs ink-jet onto the cylindrical surface of the roller in a helical track to spray a desired ink pattern onto the cylindrical surface of the roller. The ink sprayed onto the roller 1 rapidly dries and forms an etch-resistant mask on the cylindrical surface of the roller 1.

The electro-chemical etching head 5 is positioned behind the print head 4 as the carrier 3 traverses from end A to end B of the roller. The etchant from the etching head 5 is controllably applied to the cylindrical surface of the cylinder 1 bearing the now dry masking ink. Only those areas of the cylinder surface not covered by the masking ink are etched by the applied etchant. In this way a desired, etched or textured surface is formed on the roller 1.

The surface of the roller 1 may be cleaned to remove all traces of the etchant after a suitable time delay. If desired the metallic surface of the roller 1 may be coated to provide certain rolling enhancing properties. For example, the metallic surface may be coated with ceramic or polymer material to give a hard wearing or low friction textured roller surface.

In order to produce the desired masking pattern on the cylindrical surface of the roller 1 it is necessary to accurately control the speed of rotation of the cylinder 1 and the speed of traverse of the carrier 3 so that the helical path traced by the print head is able to cover the entire cylindrical roller surface without overlap. The print head 4 is controlled, preferably under software control 7, to apply or print a desired masking pattern directly onto the cylindrical surface of the roller 1. With software control, individual ink droplets from the ink jet or jets of the print head 4 can be deposited with high precision onto the cylindrical roller surface. The resolution of the printed mask is in effect dependent on the resolution of the print head. The intensity of the etching process can also be controlled by varying the pulse duration and current of the pulsed electro-chemical etching.

The masking ink suitably comprises a solvent based ink, e.g. provided by Domino Printing Sciences PLC, although a hot melt type of ink could alternatively be used. Any suitable etchant can be employed, although the use of a pulsed electro-chemical etching technique enables relatively harmless etchants, e.g. sodium chloride, to be used.

The invention will now be further described with reference to the following non-limitative example.

### EXAMPLE

In order to test a system to print and etch steel rollers, an experimental top roller for a rolling mill, having a length of 100 mm, a diameter of 52.5 mm and made from quench hardened EN31 bearing steel, was rotatably mounted on a lathe to rotate the roller at a constant velocity about the longitudinal axis of the roller. An ink-jet print head was mounted on the tool-post of the lathe so that the print head could traverse along the length of the roller.

The ink-jet printer employed was an Excel Hr ink-jet printer manufactured by Videojet. The machine is designed for contactless printing of items moving past the print head. The print head had a nozzle diameter of 36 microns and a dot frequency of up to 80 KHz. The stated resolution was 170 dots per inch. The ink applied to the roller was a solvent based ink provided by Videojet.

After a masking ink pattern was applied to the cylindrical surface of the roller under computer control, the still exposed surfaces (i.e. the unmasked surfaces) of the roller were treated with an etchant using conventional etching techniques. Ferric chloride solution was chosen as a readily available, effective etchant which is relatively harmless to work with. The roller was arranged with its longitudinal axis horizontal and with its lower cylindrical surface just touching the upper surface of a bath of the ferric chloride solution etchant. On rotation of the roller, the cylindrical roller surface was refreshed with etchant on each revolution of the roller. The etching process used should be capable of:
(1) etching to the required depth without completely undercutting the mask; and
(2) maintaining the integrity of the ink mask for the duration of the etching process.

These factors may be influenced by etch time, etchant concentration, etch temperature, agitation/circulation of etchant, ink formulation and length of delay between mask printing and etching.

In order to compare the effectiveness of the process with known texturing techniques, reference is made to Figures 2 to 6.

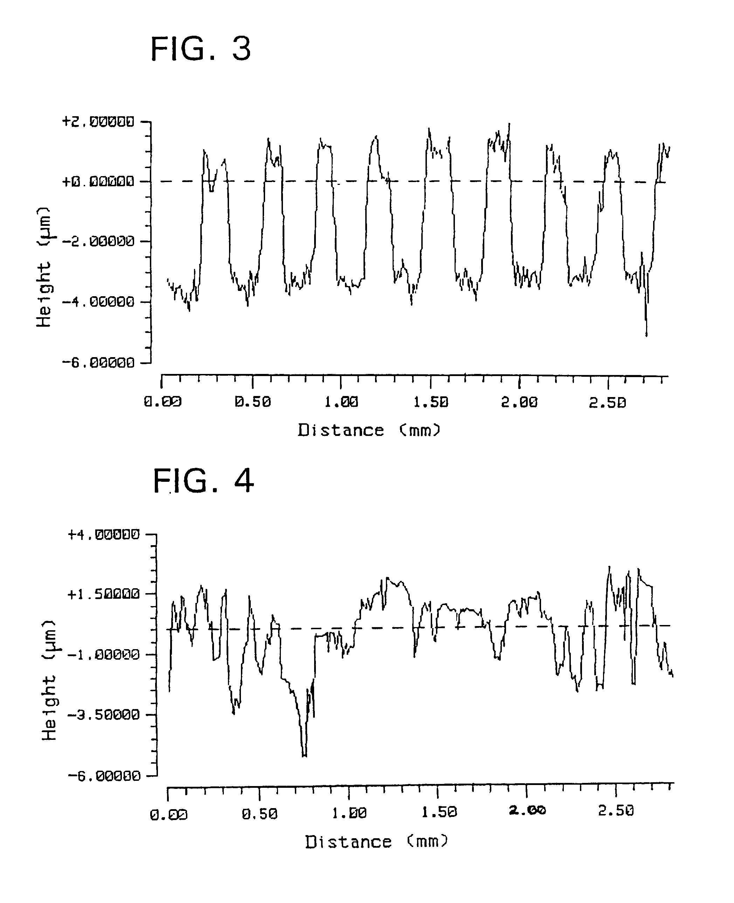

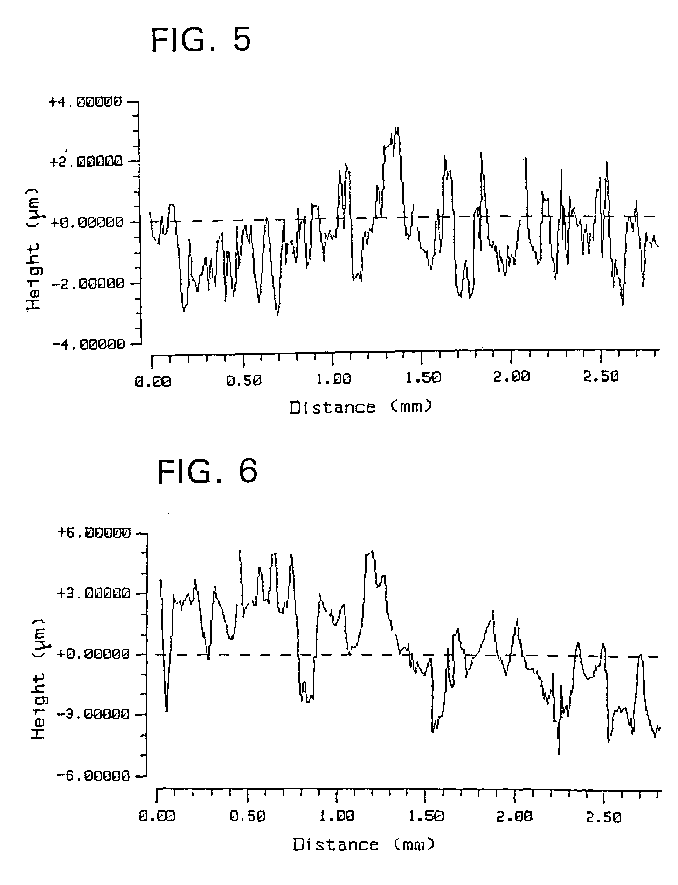

Figure 2 illustrates a quench hardened EN31 bearing steel roller after being surface textured by the process described in the foregoing example. Figures 3 and 4 illustrate 50 mm wide, 1 mm thick steel strip after annealing which, in Figure 4, is depicted before being rolled in a temper mill and which, in Figure 3, is shown after being rolled in a temper mill, the upper roll of which is surface textured as shown in Figure 2. Figures 5 and 6 show samples of conventionally textured panel steel provided, respectively, with a fine textured finish and a coarse textured finish. In each case, the plot or trace was produced on a Zygo New View 100 non-contact 3-D surface measurement system and illustrates the surface profile, measured in microns, across a 3 mm section of the sample.

The textured roller finish shown in Figure 2 has a plateau type texture, giving a good bearing surface and consistent peak height. Crater depths are typically 8 ± 2 microns, with peak counts in the range of 30-40 peaks per cm. The pattern transferred well from the roller to the annealed steel strip as can be seen in Figure 3. The map shows, however, a good consistency of valley depths even with the coarse texture (valley depths approximately 5-6 microns) shown here. This can be compared with the inconsistent nature of the original texture of the steel strip shown in Figure 4. Figures 5 and 6 show samples of conventionally textured steel, Figure 5 being a standard steel panel while Figure 6 is intended for deep drawing applications - hence the coarser, deeper texture. Neither of these conventionally textured steel panels exhibit the consistency of texture shown in Figure 3.

Although the invention has been described with respect to applying a desired surface texture to the cylindrical surface of a steel roller, e.g. for coating, rolling, pressing or otherwise treating articles, it will be appreciated that the invention has other applications. Indeed the invention is primarily concerned with applying or printing a desired pattern of masking material onto a flat or non-flat, e.g, curved, object surface, e.g. a metallic surface, to enable the unmasked part or parts of the surface to be etched or machined. The desired pattern of masked and unmasked surface areas is suitably produced by applying masking "ink" from a computer-controlled ink-jet printer. In this way the masking ink can be applied with high precision to produce the desired pattern.

Other areas where the invention can be employed are in the application of words, logos, bar codes or the like to metal surfaces and in the manufacture of printed circuit boards and photochemical machining. Although the ultimate resolution of photo-etching may be greater, the direct deposition method of the present invention offers the potential of providing quick in-house prototyping facilities at relatively low cost. An example of such an application would be a "desktop" printed circuit board prototyping unit which could accept standard output from an electronics CAD package to produce a board ready for etching within a few minutes. The etching can be performed in the same machine as produced the masking. A further example would use the high speed combined mask and electrochemical etch process for on-line permanent product marking on production lines.

A method according to the present invention offers at least some of the following specific advantages:
1. Direct control of a print head as it lays a mask enabling an accurate, predetermined pattern of mask to be applied.
2. Software control of the surface pattern.
3. Application to a wide-range of computer-controlled printing techniques.
4. Adaptability to a range of flat and curved surface geometries.
5. Adaptability to a range of etch resistant media mask materials.
6. Adaptability to a range of chemical and electro-chemical etching techniques.

## Claims

1. A method of treating an object (1) by selectively removing material from at least one part of a surface of the object, comprising partially masking said object surface with masking material to provide a desired pattern of masked and unmasked surface areas and treating the partially masked surface to remove material from the or each unmasked area, the or each masked area acting as a barrier to prevent said treating being effective to remove material from the object surface underlying the masked area, characterised in that the object to be treated comprises a roller (1) having a cylindrical outer surface and the masking material is directly applied, e.g. printed, onto the cylindrical outer surface from an applying unit (4) which moves along the length of the roller (1) as the latter is rotated to provide said desired pattern of masked and unmasked surface areas.

2. A method of applying a permanent pattern to an object (1) by selectively removing material from at least one part of a surface of the object, comprising directly applying to the object surface liquid masking material applied from an applying unit (4) moving in a path over the object surface and allowing the masking material to dry to provide a desired pattern of masked and unmasked surface areas and applying etchant to the object surface to remove material from the or each unmasked area, the or each masked area acting as a barrier to prevent the etchant being effective to remove material from the object surface underlying the masked area, characterised in that the etchant is applied to the object surface from a pulsed electro-chemical etching unit (5) which follows the same path over the object surface as that taken by the applying unit (4) to provide said desired pattern of masked and unmasked surface areas.

3. A method according to claim 1 or 2, characterised in that the object is metallic.

4. A method according to claim 1, 2 or 3, characterised in that the masking material is applied onto the object surface under computer control (7).

5. A method according to any one of the preceding claims, characterised in that the masking material is printed onto the object surface by an ink-jet printing head (4).

6. A method according to claim 2 or any one of claims 3 to 5 when dependent on claim 2, characterised in that the object surface is not flat.

7. A method according to claim 1 or any one of claims 3 to 5 when dependent on claim 1, characterised in that the material is removed from the unmasked area(s) of the object surface by chemical etching or by electro-chemical machining.

8. A method according to claim 7, characterised in that the etching comprises pulsed electro-chemical etching.

9. A method according to claim 2 or any one of claims 3 to 5 when dependent on claim 2, characterised in that the applying and etching units (4,5) are carried on a carrier (3) which is moved relative to the object surface to directly apply the masking material from the applying unit (4), and subsequently to apply etchant from the etching unit (5), to the object surface.

10. A method according to any one of the preceding claims, characterised in that the masking material comprises a solvent based ink or a hot melt type ink.

11. Apparatus for performing the method according to claim 1, characterised in that the apparatus includes an ink-jet printing head (4) for applying masking ink directly to the cylindrical outer surface, computer control means (7) for controlling the pattern of masked areas applied by the printing head (4) to the cylindrical outer surface and etching means (5) for removing material from unmasked areas of the cylindrical outer surface.

## Patentansprüche

1. Verfahren zum Behandeln eines Gegenstands (1) durch gezieltes Entfernen von Material von mindestens einem Teil der Oberfläche des Gegenstands, das folgendes umfaßt: teilweises Maskieren der Oberfläche des Gegenstands mit Maskierungsmaterial, um ein gewünschtes Muster aus maskierten und unmaskierten Oberflächenbereichen zu bilden, und Behandeln der teilweise maskierten Oberfläche, um von dem bzw. jedem unmaskierten Bereich Material zu entfernen, wobei der bzw. jeder maskierte Bereich als Sperre dient, um zu verhindern, daß das Behandeln von der unter dem maskierten Bereich liegenden Oberfläche des Gegenstands wirksam Material entfernt, dadurch gekennzeichnet, daß der zu behandelnde Gegenstand eine Walze (1) mit einer zylindrischen Außenfläche umfaßt und das Maskierungsmaterial auf die zylindrische Außenfläche von einer Auftragseinheit (4), die sich entlang der Länge der Walze (1) bewegt, während letztere gedreht wird, direkt aufgetragen wird, zum Beispiel gedruckt wird, um das gewünschte Muster aus maskierten und unmaskierten Oberflächenbereichen zu bilden.

2. Verfahren zum Auftragen eines permanenten Musters auf einen Gegenstand (1) durch gezieltes Entfernen von Material von mindestens einem Teil einer Oberfläche des Gegenstands, das folgendes umfaßt: direktes Auftragen von flüssigem Maskierungsmaterial, das von einer sich in einem Weg über die Oberfläche des Gegenstands bewegenden Auftragseinheit (4) aufgetragen wird, auf die Oberfläche des Gegenstands und Trocknenlassen des Maskierungsmaterials, um ein gewünschtes Muster aus maskierten und unmaskierten Oberflächenbereichen zu bilden, und Auftragen eines Ätzmittels auf die Oberfläche des Gegenstands, um von dem bzw. jedem unmaskierten Bereich Material zu entfernen, wobei der bzw. jeder maskierte Bereich als Sperre dient, um zu verhindern, daß das Ätzmittel von der unter dem maskierten Bereich liegenden Oberfläche des Gegenstands wirksam Material entfernt, dadurch gekennzeichnet, daß das Ätzmittel von einer gepulsten elektrochemischen Ätzeinheit (5), die über die Oberfläche des Gegenstands den gleichen Weg zurücklegt, den die Auftragseinheit (4) nimmt, auf die Oberfläche des Gegenstands aufgetragen wird, um das gewünschte Muster aus maskierten und unmaskierten Oberflächenbereichen zu bilden.

3. Verfahren nach Anspruch 1 oder 2, dadurch gekennzeichnet, daß der Gegenstand metallisch ist.

4. Verfahren nach Anspruch 1, 2 oder 3, dadurch gekennzeichnet, daß das Maskierungsmaterial rechnergesteuert (7) auf die Oberfläche des Gegenstands aufgetragen wird.

5. Verfahren nach einem der vorhergegenden Ansprüche, dadurch gekennzeichnet, daß das Maskierungsmaterial durch einen Tintenstrahldruckkopf (4) auf die Oberfläche des Gegenstands gedruckt wird.

6. Verfahren nach Anspruch 2 oder einem der Ansprüche 3 bis 5 bei Abhängigkeit von Anspruch 2, dadurch gekennzeichnet, daß die Oberfläche des Gegenstands nicht flach ist.

7. Verfahren nach Anspruch 1 oder einem der Ansprüche 3 bis 5 bei Abhängigkeit von Anspruch 2, dadurch gekennzeichnet, daß das Material durch chemisches Ätzen oder durch elektrochemische Bearbeitung von dem bzw. den unmaskierten Bereich(en) der Oberfläche des Gegenstands entfernt wird.

8. Verfahren nach Anspruch 7, dadurch gekennzeichnet, daß das Ätzen gepulstes elektrochemisches Ätzen umfaßt.

9. Verfahren nach Anspruch 2 oder einem der Ansprüche 3 bis 5 bei Abhängigkeit von Anspruch 2, dadurch gekennzeichnet, daß die Auftragseinheit (4) und die Ätzeinheit (5) auf einem Träger (3) getragen werden, der bezüglich der Oberfläche des Gegenstands bewegt wird, um das Maskierungsmaterial von der Auftragseinheit (4) direkt aufzutragen und danach Ätzmittel von der Ätzeinheit (5) auf die Oberfläche des Gegenstands aufzutragen.

10. Verfahren nach einem der vorhergehenden Ansprüche, dadurch gekennzeichnet, daß das Maskierungsmaterial eine Druckfarbe auf Lösungsmittelbasis oder eine Druckfarbe vom Heißschmelztyp umfaßt.

11. Vorrichtung zum Ausführen des Verfahrens nach Anspruch 1, dadurch gekennzeichnet, daß die Vorrichtung einen Tintenstrahldruckkopf (4) zum direkten Auftragen von Maskierungsfarbe auf die zylindrische Außenfläche, ein Rechnersteuerungsmittel (7) zum Steuern des Musters von von dem Druckkopf (4) auf die zylindrische Außenfläche aufgetragenen maskierten Bereichen und ein Ätzmittel (5) zum Entfernen von Material von unmaskierten Bereichen der zylindrischen Außenfläche umfaßt.

## Revendications

1. Procédé de traitement d'un objet (1) par élimination sélective de matière d'au moins une partie d'une surface de l'objet, comprenant le masquage partiel de ladite surface de l'objet à l'aide d'une matière de masquage pour procurer un motif souhaité de zones de surface masquées et non masquées et le traitement de la surface partiellement masquée pour éliminer de la matière de la ou chaque surface non masquée, la ou chaque surface masquée faisant office de barrière pour empêcher que ledit traitement ne parvienne à éliminer de la matière de la surface de l'objet en dessous de la zone masquée, caractérisé en ce que l'objet à traiter comprend un rouleau (1) présentant une surface cylindrique extérieure et la matière de masquage est directement appliquée, par ex. imprimée, sur la surface cylindrique extérieure à partir d'une unité d'application (4) qui se déplace sur la longueur du rouleau (1) alors que ce dernier est entraîné en rotation pour fournir ledit motif souhaité de zones de surface masquées et non masquées.

2. Procédé d'application d'un motif permanent sur un objet (1) par élimination sélective de matière d'au moins une partie d'une surface de l'objet, comprenant l'application directe sur la surface de l'objet d'une matière de masquage liquide appliquée à partir d'une unité d'application (4) se déplaçant dans un chemin sur la surface de l'objet et le fait de laisser sécher la matière de masquage pour fournir un motif souhaité de zones de surfaces masquées et non masquées et l'application de réactif d'attaque sur la surface de l'objet pour éliminer de la matière de la ou chaque zone non masquée faisant office de barrière pour empêcher que ledit réactif chimique ne parvienne à éliminer de la matière de la surface de l'objet en dessous de la zone masquée, caractérisé en ce que le réactif chimique est appliqué sur la surface de l'objet à partir d'une unité d'attaque électrochimique à impulsions (5) qui suit le même chemin sur la surface de l'objet que celui emprunté par l'unité d'application (4) pour fournir ledit motif souhaité de zones de surface masquées et non masquées.

3. Procédé selon la revendication 1 ou 2, caractérisé en ce que l'objet est métallique.

4. Procédé selon la revendication 1, 2 ou 3, caractérisé en ce que la matière de masquage est appliquée sur la surface de l'objet sous commande informatique (7).

5. Procédé selon l'une quelconque des revendications précédentes, caractérisé en ce que la matière de masquage est imprimée sur la surface de l'objet à l'aide d'un tête d'impression à jet d'encre (4).

6. Procédé selon la revendication 2 ou l'une quelconque des revendications 3 à 5 lorsqu'elle dépend de la revendication 3, caractérisé en ce que la surface de l'objet n'est pas plane.

7. Procédé selon la revendication 1 ou l'une quelconque des revendications 3 à 5 lorsqu'elle dépend de la revendication 1, caractérisé en ce que la matière est éliminée de la ou des zone(s) non masquée(s) de la surface de l'objet par attaque chimique ou par usinage électrochimique.

8. Procédé selon la revendication 7, caractérisé en ce que l'attaque comprend une attaque électrochimique à impulsions.

9. Procédé selon la revendication 2 ou l'une quelconque des revendications 3 à 5 lorsqu'elle dépend de la revendication 2, caractérisé en ce que les unités d'application et d'attaque (4, 5) sont transportées sur un support (3) qui est déplacé par rapport à la surface de l'objet pour appliquer directement la matière de masquage à partir de l'unité d'application (4) et pour appliquer ensuite du réactif d'attaque à partir de l'unité d'attaque (5) sur la surface de l'objet.

10. Procédé selon l'une quelconque des revendications précédentes, caractérisée en ce que la matière de masquage comprend une encre à base de solvant ou une encre de type thermofusible.

11. Dispositif de mise en oeuvre du procédé selon la revendication 1, caractérisé en ce que le dispositif comporte une tête d'impression à jet d'encre (4) pour appliquer de l'encre de masquage directement sur la surface cylindrique extérieure, un moyen de commande informatique (7) pour piloter le motif de zones masquées appliqué par la tête d'impression (4) sur la surface cylindrique extérieure et un moyen d'attaque (5) pour éliminer de la matière de zones non masquées de la surface cylindrique extérieure.
